(19) Europäisches Patentamt
European Patent Office
Office européen des brevets

(11) **EP 2 664 651 B1**

(12) **EUROPEAN PATENT SPECIFICATION**

(45) Date of publication and mention of the grant of the patent:
**27.03.2019 Bulletin 2019/13**

(21) Application number: **12734307.7**

(22) Date of filing: **10.01.2012**

(51) Int Cl.:
*C08L 63/00* [(2006.01)]        *C08F 220/10* [(2006.01)]
*C08L 33/06* [(2006.01)]        *C08F 220/18* [(2006.01)]
*C08F 2/20* [(2006.01)]

(86) International application number:
**PCT/JP2012/050274**

(87) International publication number:
**WO 2012/096256 (19.07.2012 Gazette 2012/29)**

(54) **CROSSLINKED POLYMER PARTICLES FOR EPOXY RESINS, EPOXY RESIN COMPOSITION, AND CURED EPOXY ARTICLE**

VERNETZTE POLYMERTEILCHEN FÜR EPOXIDHARZE, EPOXIDHARZZUSAMMENSETZUNG UND GEHÄRTETER EPOXIDARTIKEL

PARTICULES DE POLYMÈRE RÉTICULÉ POUR DES RÉSINES ÉPOXY, COMPOSITION DE RÉSINE ÉPOXY ET ARTICLE ÉPOXY DURCI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.01.2011 JP 2011002737**

(43) Date of publication of application:
**20.11.2013 Bulletin 2013/47**

(73) Proprietor: **Mitsubishi Chemical Corporation**
**Tokyo 100-8251 (JP)**

(72) Inventors:
• **NISHII, Hiroyuki**
**Tokyo 100-8251 (JP)**
• **KASAI, Toshihiro**
**Tokyo 100-8251 (JP)**

(74) Representative: **Ter Meer Steinmeister & Partner**
**Patentanwälte mbB**
**Nymphenburger Straße 4**
**80335 München (DE)**

(56) References cited:
WO-A1-2010/013407      JP-A- 8 100 163
JP-A- 2005 350 646      JP-A- 2005 350 647
JP-A- 2009 249 569      JP-A- 2010 053 199
JP-A- 2010 090 371      JP-A- 2010 275 354
US-A1- 2009 036 607

## Description

### TECHNICAL FIELD

The invention relates to a cross-linked polymer particle for an epoxy resin, an epoxy resin composition containing the cross-linked polymer particle, an epoxy resin and a curing agent, and a cured epoxy material obtained by curing the resin composition. The cured epoxy material is excellent in thermal resistance, moisture resistance, light resistance, adhesion effect, transparency and electrical properties and has no problem of brittleness, and is thus useful in applications relating to optical semiconductors such as light-emitting diode (LED) and charge-coupled device (CCD), especially the molding compounds of LED devices emitting short-wavelength lights.

### BACKGROUND ART

Recently, light-emitting apparatuses such as optical semiconductors (LED) having been utilized in various display panels, light sources for image reading, traffic signals, large display units and so on are fabricated with resin sealing. In general, the sealing resin includes an aromatic epoxy resin and an acid anhydride acting as a curing agent. Moreover, with the leap of advance of current LED, high output and short wavelength of LED devices have started to be realized quickly. Particularly, LED devices using nitride semiconductors emit short-wavelength lights in a high output.
If the above sealing resin is used to seal LED devices using nitride semiconductors, the aromatic rings of the aromatic epoxy resin contained in the sealing resin will absorb the short-wavelength light, so that the sealing resin will degrade with time and easily cause reduction of emitting brightness due to yellowing. Therefore, a sealing resin containing an alicyclic epoxy resin composition is proposed to serve as a sealing resin not reducing the colorless transparency (Patent Document 1).
However, the cured epoxy material obtained by curing the sealing resin proposed by Patent Document 1 is characterized in poor crack resistance and easily has crack damage possibly due to heating-cooling cycles, and is not suitable for applications requiring long-time reliability. To solve the problem, a sealing resin not degrading in colorless transparency and having a good crack resistance is desired.
To improve the crack resistance, a resin composition adding with rubber particles is proposed (Patent Document 2). However, because the refractive index of the rubber particle having rubber elasticity in normal temperature depends on the temperature, the refractive index difference between the rubber particles and the cured epoxy resin as the resin matrix increases in high temperature, so that the transparency may be degraded in the high temperature zone.

### CITATION LIST

Patent Literature

[Patent Document 1] Japan Patent Publication No. 2003-82062 gazette
[Patent Document 2] Japan Patent Publication No. 2010-53199 gazette.

WO 2010/013407 discloses an optical semiconductor sealing resin composition comprising a rubber-particle-dispersed epoxy resin.
JP 2010-90371 discloses an epoxy resin composition which includes an epoxy resin, a curing agent, and a rubbery graft copolymer.

### SUMMARY OF THE INVENTION

Technical Problem

The invention is made in view of the foregoing, and aims to provide a cross-linked polymer particle for an epoxy resin that does not degrade the colorless transparency and improves the crack resistance of the cured epoxy material, an epoxy resin composition containing the cross-linked polymer particle, an epoxy resin and a curing agent, and a cured epoxy material obtained by curing the resin composition.

Solution to Problem

The cross-linked polymer particle for an epoxy resin of this invention includes a (meth)acrylate monomer unit and a cross-linking monomer unit, has a volume-average primary particle size of 0.5 to 10 $\mu$m, has a glass transition temperature of 30°C or higher that is obtained by the FOX equation with respect to the monomer components excluding the cross-linking monomer, and has a refractive index of 1.490 to 1.510 at 23°C.

The epoxy resin composition of the invention includes the above cross-linked polymer particle (C), an epoxy resin (A), and an epoxy-resin curing agent (B).

The cured epoxy material of the invention is obtained by curing the above resin composition, and is particularly a molding compound for LED.

[Effects of Invention]

The cross-linked polymer particle for epoxy resin and the epoxy resin composition of the invention can improve the crack resistance of the cured epoxy material without degrading the colorless transparency.

DESCRIPTION OF EMBODIMENTS

The epoxy resin (A) used in the invention is represented by an epoxy resin having two or more epoxy groups in one molecule. Examples of preferred epoxy resin (A) are bisphenol A-type epoxy resin, bisphenol F-type epoxy resin, bisphenol S-type epoxy resin, o-cresol novolac-type epoxy resin, alicyclic epoxy resin, triglycidyl isocyanurate and aliphatic epoxy resin. The epoxy resins can be used alone or in combination of two or more.

In the aspect of not absorbing short-wavelength light and not degrading colorless transparency, alicyclic epoxy resin is preferred among these epoxy resins. Specific example of the alicyclic epoxy resin are 3,4-epoxycyclohexylmethyl 3',4'-epoxy- cyclohexanecarboxylate (trade name: Celloxide 2021), an adduct of 3,4-epoxy- cyclohexylmethyl 3',4'-epoxycyclohexanecarboxylate with a dimer of $\varepsilon$-caprolactone (trade name: Celloxide 2081) and 1,2,8,9-diepoxylimonene (trade name: Celloxide 3000) that are all produced by Diacel Chemical Industries Company, hydrogenated alicyclic epoxy resin of bisphenol A-type (trade names: YX-8000 and YX-8034, produced by Mitsubishi Chemical Corporation; and trade name: EPICLON 750, produced by DIC Corporation).

The epoxy resin curing agent (B) is a curing agent causing a curing reaction of the epoxy resin (A). Particularly in the applications of sealing resin, a curing agent having relatively less coloring is preferred. The curing agent is preferably an acid anhydride- type curing agent and more preferably an alicyclic acid anhydride-type curing agent. Specific examples thereof are hexahydrophthalic anhydride, methylhexahydrophthalic anhydride, tetrahydrophthalic anhydride, and hydrogenated methylnadic anhydride. The curing agents can be used alone or in combination of two or more.

The cross-linked polymer particle (C) of this invention is used as a filler for epoxy resin and contains a (meth)acrylate monomer unit and a cross-linking monomer unit. Particularly, the (meth)acrylate monomer unit preferably includes a monomer unit with cycloalkyl group. When the (meth)acrylate monomer unit includes a monomer unit with cycloalkyl group, the cross-linked polymer particle (C) will not absorb short-wavelength light and les degrade the colorless transparency. The cross-linked polymer particle (C) may be obtained by, e.g., polymerizing a (meth)acrylate monomer (c1) and a cross-linking monomer (c2). Further, "(meth)acryl" is the generic term of "acryl" and "methacryl".

Examples of the (meth)acrylate monomer (c1) are: (meth)acrylate esters of straight alkyl alcohols, such as methyl (meth)acrylate, ethyl (meth)acrylate, *n*-butyl (meth)acrylate, *i*-butyl (meth)acrylate, *t*-butyl (meth)acrylate, hexyl (meth)acrylate, 2-ethylhexyl (meth)acrylate, and octyl (meth)acrylate; monomers containing sulfonic acid group, such as allylsulfonic acid; (meth)acrylate esters containing a phosphoric group, such as 2-(meth)acryloyloxyethyl acidic phosphate; carbonyl-containing (meth)acrylate esters, such as acetoacetoxyethyl (meth)acrylate; amino-containing (meth)acrylate esters, such as N-dimethylaminoethyl (meth)acrylate, and N-diethylaminoethyl (meth)acrylate; and cycloalkyl group -containing vinyl monomers, such as cyclohexyl acrylate, cyclohexyl methacrylate, dicyclopentanyl acrylate, dicyclopentanyl methacrylate, tricyclodecyl acrylate, tricyclodecyl methacrylate, isobornyl (meth)acrylate, and adamantyl (meth)acrylate. The (meth)acrylate ester monomers can be used alone or in combination of two or more.

Examples of the cross-linking monomer (c2) are: alkylene glycol dimethacrylates, such as ethylene glycol dimethacrylates, 1,3-butylene glycol dimethacrylates, 1,4-butylene glycol dimethacrylates, and propylene glycol dimethacrylates; allyl methacrylate; and polyvinylbenzenes, such as divinylbenzene and trivinylbenzene. The cross-linking monomers can be used alone or in combination of two or more.

The cross-linked polymer particle (C) preferably also includes at least a functional group selected from carboxyl, hydroxyl and glycidyl to further improve the colorless transparency of the obtained cured epoxy material. Moreover, the function group can react with the epoxy resin (A) or the epoxy resin curing agent to further improve the interface strength between the cross-linked polymer particle (C) and the matrix resin phase. The cross-linked polymer particle having such a functional group may be obtained by, e.g., using a vinyl monomer (c3) having at least a functional group selected from carboxyl, hydroxyl and glycidyl in the polymerization of the monomers.

In view of the ease of aqueous polymerization, the cross-linked polymer particle (C) preferably has glycidyl groups.

Examples of the vinyl monomer (c3) having carboxyl as the functional group are: acrylic acid, methacrylic acid, crotonic acid, maleic acid, itaconic acid, fumaric acid, methacrylic acid, vinyloxyacetic acid, allyloxyacetic acid, 2-(meth)acryloylpropionic acid, 3-(meth)acryloylbutanoic acid, 4-vinlbenzoic acid, 2-methacryloyloxyethyl-succinic acid, 2-methacryloyloxyethylmaleic acid, 2-methacryloyloxyethylphthalic acid, and 2-methacryloyloxyethylhexahydrophthalic acid. Examples of the vinyl monomer (c3) having hydroxyl as the functional group are: hydroxymethyl (meth)acrylate, 2-hydroxyethyl (meth)acrylate, 2-hydroxypropyl (meth)acrylate, and 2-hydroxybutyl (meth)acrylate. An example of the vinyl monomer (c3) having glycidyl as the functional group is glycidyl (meth)acrylate. The vinyl monomers can be used alone or in combination of two or more, wherein the (meth)acryl-type monomers such as methacrylic acid, 2-hydroxyethyl methacrylate, and glycidyl methacrylate.

The content of the cycloalkyl group -containing vinyl monomer (c1) relative to all the used monomers of 100 mass% is preferably 60 to 99.5 mass% and more preferably 69.9 to 99 mass%. The content of the multi-functional vinyl monomer (c2) relative to all the used monomers of 100 mass% is preferably 0.5 to 40 mass% and more preferably 0.9 to 30 mass%. When the content of the multi-functional vinyl monomer (c2) is 0.5 mass% or more, there is a tendency that the particle is difficult to swell and the system is difficult to tackify. When the content of the multi-functional vinyl monomer (c2) is 40 mass% or less, the polymerization tends to be stable. The content of the vinyl monomer (c3) relative to all the used monomers of 100 mass% is preferably 0 to 50 mass%, more preferably 1 to 40 mass% and particularly preferably 10 to 40 mass%. When the content of the vinyl monomer (c3) is 0.1 mass% or more, the interface strength between the cross-linlced polymer particle (C) and the matrix layer is improved. When the content of the vinyl monomer (c3) is 50 mass% or less, the polymerization tends to be stable.

The cross-linked polymer particle (C) of the invention can be produced using a well-known polymerization method, such as emulsion polymerization, soap-free polymerization, or seed emulsion polymerization, swelling polymerization or two-stage swelling polymerization using polymer particles obtained by the above polymerization methods as seeds, or fine suspension polymerization, etc., wherein the fine suspension polymerization is particularly preferred. The fine suspension polymerization may be the following method, for example. An aqueous mixture of monomers, a surfactant, water and an oil-soluble initiator is forcibly emulsified using a homogenizer or a homo-mixer to form fine droplets with a particle size of 1.0 to 100 $\mu$m. The droplets are heated to decompose the oil-soluble initiator dissolved in the droplets and thereby form radicals to cause radical polymerization. Thus, an emulsion dispersed with the cross-linked polymer particle (C) is obtained.

As the surfactant, any surfactant of anion type, cation type or non-ion type can be used. Examples of the anionic surfactant include: carboxylate salts, such as potassium oleate, sodium stearate, sodium myristate, sodium N-lauroylsarcosinate, and dipotassium alkenylsuccinate; sulfate ester salts, such as sodium lauryl sulfate, and ammonium lauryl sulfate; sulfonate salts, such as, sodium dioctylsulfosuccinate, ammonium di(2-ethylhexyl)sulfosuccinate, sodium dodecylbenzenesulfonate, and sodium alkyldiphenyletherdisulfonate; phosphate ester salts, such as sodium polyoxyethy lenealkyletherphosphate.

The addition amount of the surfactant can be suitably determined according to the surfactant used, the species or combination ratio and the polymerization conditions. Usually, the amount is preferably 0.1 mass part or more, and more preferably 0.5 mass part or more, relative to 100 mass parts of the monomers. Moreover, in order to reduce the residual amount in the polymer, the amount is preferably 10 mass parts or less, and more preferably 5 mass parts or less.

The oil-soluble initiator is represented by radical polymerization initiators having a water solubility less than 0.5 mass%. Specific examples thereof include: azo-type radical polymerization initiators, such as azonitrile, azoamide, cyclic azoamidine, azoamidine, and macro-azo-compounds; and peroxide-type radical polymerization initiators, such as ketoneperoxide, peroxyketal, hydroperoxide, dialkylperoxide, diacylperoxide, peroxyester, and peroxydicarbonate. The amount of the oil-soluble initiator used is preferably 0.05 to 1.0 mass relative to the monomers of 100 mass parts.

The amount of the used water in the aqueous mixture is preferably from 50 to 1000 mass parts relative to the total amount of the monomers of 100 mass parts.

If required, an antioxidant or an additive can be added in the emulsion of the cross-linked polymer particle (C).

The cross-linked polymer particle (C) can be collected in the powder form from the emulsion dispersed with the cross-linked polymer particle (C) by, for example, salt- or acid-separation aggregation, spray-drying, or freeze-drying, etc. Particularly, spray- drying can lower the thermal history of the particle and is therefore preferred. The drying method of the spray-drying is not particularly limited, any may be a well-known method of two-fluid nozzle type, pressure nozzle type or rotation disk type. The outlet temperature of the drying chamber of the spray-drying is preferably 50°C to 120°C and more preferably 60°C to 100°C.

The cross-linked polymer particle (C) has a glass transition temperature of 30°C or higher, preferably 50°C or higher, that is obtained by the FOX equation with respect to the monomer components excluding the cross-linking monomer. If the glass transition temperature is lowered than 30°C, then under a high-temperature condition, for example, the relative refractive index of the cross-linked polymer particle (C) with respect to the matrix resin may be outside of the range of 0.99 to 1.01 degrading the transparency of the resin composition.

For example, when two kinds of monomers other than the crosslinking monomer are used to form the cross-linked polymer particle (C), based on the glass transition temperatures Tg1 and Tg2 of the respective homo-polymers of the monomer (1) and the monomer (2), the glass transition temperatures Tg of the copolymer formed from the two components of the monomer (1) and the monomer (2) can be obtained as a calculated value using the following FOX equation (an example of two components).

$$1/Tg = W1/Tg1 + W2/Tg2 \text{ (wherein } W1+W2=1)$$

W1: the weight fraction of the monomer (1)
W2: the weight fraction of the monomer (2)
Tg1: the glass transition temperature (K) of the homo-polymer of the monomer (1)
Tg2: the glass transition temperature (K) of the homo-polymer of the monomer (2)

The volume-average primary particle size is 0.5 to 10 $\mu$m, preferably 0.7 to 7 $\mu$m and more preferably 0.8 to 4.0 $\mu$m. When the volume-average primary particle size is 0.5 $\mu$m or more, the dispersibility of the cross-linked polymer particle (C) in the resin composition is excellent. When the volume-average primary particle size is 10 $\mu$m or less, the transparency of the cured epoxy material is not degraded. The volume-average primary particle size is measured by a laser diffraction scattering method. The measurement may utilize a well-known particle-size distribution measuring apparatus of laser diffraction/scattering type.

The refractive index of the cross-linked polymer particle (C) at 23°C is 1.490 to 1.510, which is measured according to the JIS K7142.

The epoxy resin composition of the invention includes the aforementioned cross- linked polymer particle (C), epoxy resin (A) and epoxy resin curing agent (B). The content of the epoxy resin curing agent (B) is preferably 0.7 to 1.4 time the epoxy equivalent of the epoxy resin (A). The content of the cross-linked polymer particle (C) is preferably 5 to 80 mass parts and more preferably 10 to 50 mass parts relative to 100 mass parts of the epoxy resin (A). When the content is 5 mass parts or more, the cured epoxy material sufficiently shows crack resistance to have raised long-time reliability. When the content is 80 mass parts or less, the viscosity of the resin composition will not be increased remarkably, and the epoxy resin composition is easy to manipulate.

In the epoxy resin composition of the invention, the relative refractive index (Rm/Rc) of the refractive index (Rm) at 23°C of the cured material obtained by curing the epoxy resin (A) and the epoxy resin curing agent (B) with respect to the refractive index (Rc) of the cross-linked polymer particle (C) at 23°C is preferably 0.99 to 1.01 and more preferably 0.995 to 1.005. When the relative refractive index (Rm/Rc) is within the above range, an increase of the scattering loss of light on the surface of the cross-linked polymer particle (C) can be inhibited, and the colorless transparency of the epoxy resin composition can be maintained. The refractive indexes are measured according to the JIS K7142.

The epoxy resin composition of the invention may also contain a curing promoter, if only the colorless transparency of the obtained cured epoxy material is not degraded. The curing promoter has the effect of promoting the reaction of the epoxy resin (A) and the epoxy resin curing agent (B). The curing promoters suitably used in sealing resin are those having relatively less coloring. Specific examples thereof include: organic phosphine-type curing promoters, such as triphenylphosphine and diphenylphosphine; imidazole-type curing promoters, such as 2-methylimidazole, 2-phenyl-4-methyl- imidazole and 2-phenylimidazole; tertiary amine-type curing promoters, such as 1,8-diazabicyclo(5,4,0)-7-undecene, triethanolamine, and benzyldimethylamine; and tetraphenylborate-type curing promoters, such as tetraphenylphosphonium tetraphenylborate. The curing promoters can be used alone or in combination of two or more. The combination proportion of the curing promoter is preferably 0.01 to 3 mass% relative to the epoxy resin composition of 100 mass%.

The epoxy resin composition of the invention is obtained as a composition where the epoxy resin curing agent (B) and the cross-linked polymer particle (C) are dispersed in the epoxy resin (A), possibly by blending all the components using a blender such as a vacuum blender. Moreover, if required, it is possible to conduct pulverization using a pulverizer such as a ball mill.

The cured epoxy material is obtained by curing the aforementioned epoxy resin composition of the invention. The curing method is not particularly limited. For example, light and heat can be utilized to perform a curing reaction to form the cured epoxy material.

With the epoxy resin composition of the invention, the colorless transparency is not degraded, and the crack resistance of the cured epoxy material is improved. Moreover, the cured epoxy material of the invention also has good electrical characteristics. Thus, the cured epoxy material of the invention can be suitably used in applications of the molding compounds of electrical/electronic parts, such as insulating materials. Also, as having higher transparency and toughness, the cured epoxy material of the invention is suitable for the applications of optical semiconductor molding compounds, adhesives for optical uses and various sealing agents, especially molding compounds of LED.

[Examples]

The invention is specifically described below with the embodiments, which are however not intended to apply any restriction on the invention. The terms "part" and "%" used in the following text represent "mass part" and "mass%", respectively.

The values of volume-average primary particle size described in the following embodiments were obtained by using a particle-size distribution measuring apparatus (SALD-7100, made by Shimadzu Corporation) to measure the volume-average median size. The concentration of an emulsion sample was suitably adjusted such that a suitable range is achieved in the scattered light intensity monitor attached to the apparatus.

[Fabrication Example 1] Cross-linked polymer particle (C-1)

In a 2 L separable flask equipped with a stirrer, a reflux cooling tube, a temperature control apparatus and a nitrogen introduction tube, 175 parts of ion-exchange water was added. Then, in a beaker with a certain size, 100 parts of ion-exchange water, 90 parts of cyclohexyl methacrylate as the vinyl monomer (c1), 10 parts of ethylene glycol dimethacrylate as the crosslinking monomer (c2), 1 part of sodium dodecylbenzene- sulfonate as a surfactant, and 0.2 part of 1,1,3,3-tetramethylbutylperoxy- 2-ethylhexanoate (trade name: "Perocta O", produced by NOF Corporation) as an oil-soluble initiator are mixed. A mixer "Ultra-Turrax T-25" made by IKA Company was used to treat the mixture for 3 minutes to obtain a monomer emulsion.

The obtained monomer emulsion was poured in the separable flask and heated to 70°C. An exothermic peak accompanying with the polymerization reaction was observed when the system temperature was around 70°C, and the system temperature increased to 78°C. The reaction solution was placed still for 30 minutes after the exothermic peak was observed, and the temperature was raised to 80°C and maintained for 60 min. The solid content of the emulsion of the obtained cross-linked polymer particle (C-1) was 23.8%. The volume-average primary particle size of the cross-linked polymer particle (C-1) was 2.57 $\mu$m.

A spray-dryer (trade name: "L-8", made by Ohkawara Kakohki Co., Ltd.) was used, under the conditions of the inlet temperature of the drying gas being 140°C, the outlet temperature being 70°C and the atomizer rotation speed being 25,000 rpm, to spray the emulsion of the cross-linked polymer particle (C-1) and obtain a powder of the cross-linked polymer particle (C-1).

[Fabrication Example 2] Cross-linked polymer particle (C-2)

A powder of the cross-linked polymer particle (C-2) was obtained in the same way as in Fabrication Example 1 except that 80 parts of cyclohexyl methacrylate was used as the vinyl monomer (c1), 10 parts of ethylene glycol dimethacrylate was used as the crosslinking monomer (c2) and 10 parts of glycidyl methacrylate was used as the vinyl monomer (c3) having glycidyl. The solid content of the emulsion of the cross-linked polymer particle (C-2) was 23.6%. The volume-average primary particle size of the cross-linked polymer particle (C-2) was 2.64 $\mu$m.

[Fabrication Example 3] Core-shell polymer particle (D-1)

In a 2 L separable flask equipped with a stirrer, a reflux cooling tube, a temperature control apparatus and a nitrogen introduction tube, 143.3 parts of ion-exchange water was added. Then, 2.8 parts of butyl acrylate, 2.2 parts of styrene, and 0.1 part of allyl methacrylate were added, and the mixture was heated to 80°C. When the system temperature reached 80°C and was confirmed to be stable, an aqueous solution of ammonium persulfate, which was obtained by dissolving 0.1 part of ammonium persulfate in 6.1 parts of ion-exchange water, was added in the system to perform polymerization of seed particles. After an exothermic peak was observed, the system was maintained for 30 minutes to obtain seed particles.

Next, as core components, 45.5 parts of butyl acrylate, 18.4 parts of styrene, 1.6 part of allyl methacrylate, 0.6 part of ammonium di-2-ethylhexylsulfosuccinate as an emulsifying agent, and 31.9 parts of ion-exchange water were weighted to a beaker with a certain size. The mixture was treated with the mixer "Ultra-Turrax T-25" made by IKA Company at 12,000 rpm for 3 minutes to form a monomer emulsion of the core. The monomer emulsion of the core was added dropwise in the system in 180 minutes, and the system was maintained for 60 minutes to run the reaction of core components.

Next, 28.9 parts of methyl methacrylate, 0.6 part of butyl acrylate, 0.4 part of ammonium di-2-ethylhexylsulfosuccinate, and 14.7 parts of ion-exchange water were weighted to a beaker with a certain size and treated with the mixture "Ultra-Turrax T-25" at 12,000 rpm for 3 minutes to form a monomer emulsion of the shell. The monomer emulsion of the shell was added dropwise in the system in 100 minutes. After the system was maintained for 60 minutes, the emulsion polymerization was terminated to obtain a core-shell polymer emulsion. The solid content of the emulsion was 33.2%, and the volume-average primary particle size was 0.40 $\mu$m.

A spray-dryer (trade name: "L-8", made by Ohkawara Kakohki Co., Ltd.) was used, under the conditions of the inlet temperature of the drying gas being 140°C, the outlet temperature being 70°C and the atomizer rotation speed being 25,000 rpm, to spray the emulsion of the obtained core-shell polymer and obtain a powder of the core-shell polymer particle (D-1).

[Fabrication Example 4] Core-shell polymer particle (D-2)

A powder of the core-shell polymer particle (D-2) was obtained in the same way as in Fabrication Example 3 except that 0.1 part of ammonium di-2-ethylhexylsulfosuccinate as an emulsifying agent was added in the seed portion. The solid content of the emulsion was 32.43%, and the volume-average primary particle size was 0.26 $\mu$m.

[Fabrication Example 5] Cross-linked polymer particle (C-3)

A powder of the cross-linked polymer particle (C-3) was obtained in the same way as in Fabrication Example 1 except that 80 parts of isobornyl methacrylate was used as the vinyl monomer (c1), 10 parts of ethylene glycol dimethacrylate was used as the cross-linking monomer (c2) and 10 parts of glycidyl methacrylate was used as the vinyl monomer (c3) having glycidyl. The solid content of the emulsion of the cross-linked polymer particle (C-3) was 20.6%. The volume-average primary particle size of the cross-linked polymer particle (C-3) was 2.29 $\mu$m,

[Fabrication Example 6] Cross-linked polymer particle (C-4)

A powder of the cross-linked polymer particle (C-4) was obtained in the same way as in Fabrication Example 1 except that 80 parts of isobornyl methacrylate was used as the vinyl monomer (c1), 10 parts of ethylene glycol dimethacrylate was used as the cross-linking monomer (c2) and 10 parts of methacrylic acid was used as the vinyl monomer (c3) having carboxyl. The solid content of the emulsion of the cross-linked polymer particle (C-4) was 18.7%. The volume-average primary particle size of the cross-linked polymer particle (C-4) was 1.99 $\mu$m.

[Fabrication Example 7] Cross-linked polymer particle (C-5)

A powder of the cross-linked polymer particle (C-5) was obtained in the same way as in Fabrication Example 1 except that 70 parts of isobornyl methacrylate was used as the vinyl monomer (c1), 10 parts of ethylene glycol dimethacrylate was used as the cross-linking monomer (c2) and 20 parts of glycidyl methacrylate was used as the vinyl monomer (c3) having glycidyl. The solid content of the emulsion of the cross-linked polymer particle (C-5) was 20.5%. The volume-average primary particle size of the cross-linked polymer particle (C-5) was 2.46 $\mu$m.

[Fabrication Example 8] Cross-linked polymer particle (C-6)

A powder of the cross-linked polymer particle (C-6) was obtained in the same way as in Fabrication Example 1 except that 60 parts of isobornyl methacrylate was used as the vinyl monomer (c1), 10 parts of ethylene glycol dimethacrylate was used as the cross-linking monomer (c2) and 30 parts of glycidyl methacrylate was used as the vinyl monomer (c3) having glycidyl. The solid content of the emulsion of the cross-linked polymer particle (C-6) was 20.7%. The volume-average primary particle size of the cross-linked polymer particle (C-6) was 2.36 $\mu$m.

The compositions and the physical properties of the particles are listed in Table 1 and Table 2. The abbreviations in the Tables are explained as follows.

CHMA: cyclohexyl methacrylate
IBXMA: isobornyl methacrylate
EDMA: ethylene glycol dimethacrylate
GMA: glycidyl methacrylate
MAA: methacrylic acid
BA: butyl acrylate
ST: styrene
AMA: allyl methacrylate
MMA: methyl methacrylate

Table 1

| | | Fabrication Example 1 | Fabrication Example 2 | Fabrication Example 5 | Fabrication Example 6 | Fabrication Example 7 | Fabrication Example 8 |
|---|---|---|---|---|---|---|---|
| | | C-1 | C-2 | C-3 | C-4 | C-5 | C-6 |
| (C) | CHMA | 90 | 80 | - | - | - | - |
| | IBXMA | - | - | 80 | 80 | 70 | 60 |
| | EDMA | 10 | 10 | 10 | 10 | 10 | 10 |
| | GMA | - | 10 | 10 | - | 20 | 30 |
| | MAA | - | - | - | 10 | - | - |
| Volume-average primary particle size [$\mu$m] | | 2.57 | 2.64 | 2.29 | 1.99 | 2.46 | 2.36 |
| Refractive index (Rc) | | 1.507 | 1.509 | 1.507 | 1.508 | 1.501 | 1.499 |
| Glass transition temperature (Tg) [°C] | | 83 | 78.5 | 135.2 | 157.4 | 121.4 | 108.5 |

Table 2

| | | Fabrication Example 3 | Fabrication Example 4 |
|---|---|---|---|
| | | D-1 | D-2 |
| Seed | Ion-exchange water | 143.3 | 143.3 |
| | BA | 2.8 | 2.8 |
| | ST | 2.2 | 2.2 |
| | AMA | 0.1 | 0.1 |
| | Emulsifying agent | 0 | 0.1 |
| Core | Ion-exchange water | 31.9 | 31.9 |
| | BA | 45.5 | 45.5 |
| | ST | 18.4 | 18.4 |
| | AMA | 1.6 | 1.6 |
| | Emulsifying agent | 0.6 | 0.6 |
| Shell | Ion-exchange water | 14.7 | 14.7 |
| | MMA | 28.9 | 28.9 |
| | BA | 0.6 | 0.6 |
| | Emulsifying agent | 0.4 | 0.4 |
| Volume-average primary particle size [$\mu$m] | | 0.4 | 0.26 |
| Refractive index (Rc) | | 1.507 | 1.504 |
| Glass transition temperature (Tg) [°C] | | 4.2 | 4.2 |

The glass transition temperature values (Tg) [°C] shown in Table 1 and Table 2 were obtained using the following FOX equation according to the glass transition temperatures of the homo-polymers of the monomer components other than the crosslinking monomer.

$$1/\text{Tg [K]} = W1/\text{Tg1} + W2/\text{Tg2} \quad (\text{wherein } W1+W2=1)$$

W1: the weight fraction of the monomer (1)

W2: the weight fraction of the monomer (2)

Tg1: the glass transition temperature (K) of the homo-polymer of the monomer (1)

Tg2: the glass transition temperature (K) of the homo-polymer of the monomer (2)

Moreover, the glass transition temperatures of the homo-polymers are the values described in Polymer Handbook (4th Ed., issued by John Wiley & Sons Inc.).
CHMA: cyclohexyl methacrylate 356 (K)
IBXMA: isobornyl methacrylate 423 (K)
GMA: glycidyl methacrylate 347 (K)
MAA: methacrylic acid 501 (K)
BA: butyl acrylate 219 (K)
ST: styrene 373 (K)
MMA: methyl methacrylate 378 (K)

[Example 1] Productions of Epoxy Resin Composition and Cured Epoxy Material

49.5 parts of a bisphenol A-type hydrogenated alicyclic epoxy resin (trade name: "YX-8000", produced by Mitsubishi Chemical Corporation) as the epoxy resin (A) and 9.9 parts of the cross-linked polymer particle (C-1) were weighted. A vacuum blender (trade name: "Debubble Kneading Taro ARV-310LED", produced by Thinky Company) was used to premix the components under the atmospheric pressure at 1200 rpm for 1 minute and then premix, while the pressure was reduced to 3 KPa, at 1200 rpm for 2 minutes. The components were then blended using a three-roll mill while the roll rotation speed was set at 150 rpm and the roll distance set at 30 $\mu$m to 5 $\mu$m, and were treated with three passes to obtain a blended material.
59.4 parts of the blended material, 40.1 parts of 4-methylhexahydrophthalic anhydride (trade name: "Rikacid MH-700", produced by New Japan Chemical Co., Ltd.) as the epoxy resin curing agent (B), 0.5 part of tetrabutylphosphonium diethylphosphodithionate (trade name: "Hishicolin PX-4ET", produced by Nippon Chemical Industrial Co., Ltd.) as a curing promoter were weighted. The vacuum blender (Debubble Kneading Taro ARV-310LED) was used to blend and debubble the components under the atmospheric pressure at 1200 rpm for 1 minute and then blend and debubble, while the pressure was reduced to 3 KPa, at 1200 rpm for 2 minutes to obtain an epoxy resin composition.
The epoxy resin composition was poured in glass plates with tetrafluoroethylene resin spacers clipped in between, and was cured at 100°C for 3 hours and then at 120°C for 4 hours to obtain a cured epoxy material of 3 mm thick.

[Example 2]

An epoxy resin composition and a cured epoxy material were obtained in the same way as in Example 1 except that the cross-linked polymer particle (C-2) was used instead of the cross-linked polymer particle (C-1).

[Examples 3-8 and Comparative Examples 1-4]

An epoxy resin composition and a cured epoxy material were obtained in the same way as in Example 1 except that the combination was changed to that described in Table 3. Moreover, in Comparative Example 3 or 4, a cured material could not be obtained because remarkable tackification occurred at the blending.

[Reference Example 1]

55.0 parts of the bisphenol A-type hydrogenated alicyclic epoxy resin (YX-8000) as the epoxy resin (A), 44.5 parts of 4-methylhexahydrophthalic anhydride (Rikacid MH-700) as the epoxy resin curing agent (B), and 0.5 part of tetrabutylphosphonium diethylphosphodithionate (Hishicolin PX-4ET) as a curing promoter were weighted. The vacuum blender (Debubble Kneading Taro ARV-310LED) was used to blend and debubble the components under the atmospheric pressure at 1200 rpm for 1 minute and then blend and debubble, while the pressure was reduced to 3 KPa, at 1200 rpm for 2 minutes to obtain an epoxy resin composition. The epoxy resin composition was cured under the same conditions of Example 1 to obtain a cured epoxy material of 3 mm thick.

[Reference Example 2]

An epoxy resin composition and a cured epoxy material were obtained in the same way as in Reference Example 1 except that 44.6 parts of 3,4-epoxycyclohexylmethyl 3',4'-epoxycyclohexanecarboxylate (trade name: "Celloxide 2021P", produced by Diacel Chemical Industries Company) as the epoxy resin (A), 54.9 parts of 4-methylhexahydrophthalic anhydride (Rikacid MH-700) as the epoxy resin curing agent (B), and 0.4 part of tetrabutylphosphonium diethylphosphodithionate (Hishicolin PX-4ET) were used.
The obtained cured epoxy materials were subjected to the following evaluations (1) to (4).

Measurement of Relative Refractive Index

The refractive index (Rm) of the cured material (A+B) at 23°C was measured according to JIS K7142.
The refractive index (Rc) of the cross-linked polymer particle (C) was obtained by the following method. At first, the monomers of the specific amounts described in any of Fabrication Examples 1, 2 and 5-8 and 0.1 part of *t*-hexylperoxy pivalate (trade name: "Perhexyl PV", produced by NOF Corporation) as an initiator were weighted to a container and blended and debubbled using the vacuum blender (Debubble Kneading Taro ARV-310LED). Then, two glass plates attached with polyethylene terephthalate (PET) films were used to clip tetrafluoroethylene resin spacers, and the above monomer mixture liquid was poured between them. Polymerization was performed under conditions of 80°C×6 hours and 130°C×2 hours to fabricate test plates for refractive index measurement. The refractive index (Rc) of the test plate at 23°C was measured according to JIS K7142. The result is shown in Table 1.
The refractive index (Rc) of the core-shell polymer particle (D) was measured with the following method. The powder of the core-shell polymer particle (D) obtained in Fabrication Example 3 or 4 was thermo-compressed under the condition of 180°C and 5 MPa to fabricate sheet-like test plates for refractive index measurement. The refractive index (Rc) of the test plate at 23°C was measured according to JIS K7142. The result is shown in Table 2.
A relative refractive index (Rm/Rc) was then obtained according to the refractive index values. The result is shown in Table 3.

(2) Evaluation of Transparency

A UV-visible spectrometer (trade name "V-630" produced by JASCO Corporation) was used to measure the transmittances of the obtained cured material of 3 mm thick at wavelengths of 600 nm, 450 nm and 400 nm, respectively. Meanwhile, a haze meter (trade name "HR-100" produced by Murakami Color Research Laboratory Co., Ltd.) was used to measure the haze values of the cured materials under the conditions of 23°C and 80°C, respectively, to investigate the temperature dependencies of transparency of the cured materials.

(3) Crack Resistance

An epoxy resin composition obtained in the same way as in Example 1 was placed in an aluminum schale together with a clip for business (trade name "Gem Clip No. 13", made by LION Office Products Corp.), and was cured under conditions of 100°C×3 hours and then 120°C×4 hours to obtain a cured material of 5 mm thick encapsulating a clip. Moreover, each clip for business is used to one aluminum schale. Each cured material was subjected to repeated thermal processes under the following condition, and was observed by eyes for presence or absence of cracks. The test was conducted with n=5, and eye confirmation was done every three cycles. The cycle conditions under which the number of crack occurrences reached 3 were counted.

Cycle conditions:

1: -10°C×30 min→105°C×30 min, 3 cycles
2: -20°C×30 min→105°C×30 min, 3 cycles
3: -30°C×30 min→105°C×30 min, 3 cycles
4: -40°C×30 min→105°C×30 min, 3 cycles
5: -55°C×30 min→105°C×30 min, 3 cycles
6: -55°C×30 min→130°C×30 min, 3 cycles

7: -55°C×30 min→150°C×30 min, 3 cycles

(4) Electrical Characteristics

An impedance analyzer (trade name: "E4991A", made by Agilent Technologies, Inc.) was used to measure the dielectric constants and dielectric tangents of the obtained cured materials of 3 mm thick at 10 MHz, 100 MHz and 1 GHz. The smaller the dielectric constant and dielectric tangent are, the better the insulating property is.

The abbreviations in Table 3 are explained as follows.

YX-8000: bisphenol A-type hydrogenated alicyclic epoxy resin (trade name: "YX-8000", produced by Mitsubishi Chemical Corporation)

Celloxide 2021P: 3,4-epoxycyclohexylmethyl 3',4'-epoxycyclohexanecarboxylate (trade name: "Celloxide 2021P", produced by Diacel Chemical Industries Company)

MH-700: 4-methylhexahydrophthalic anhydride (trade name: "Rikacid MH-700", produced by New Japan Chemical Co., Ltd.)

PX-4ET: tetrabutylphosphonium diethylphosphodithionate (Hishicolin PX-4ET)

Table 3

| | | aR. 1 | R. 2 | bE. 1 | E. 2 | E. 3 | E. 4 | E. 5 | E. 6 | E. 7 | E. 8 | cCE.1 | CE.2 | CE.3 | CE.4 |
|---|---|---|---|---|---|---|---|---|---|---|---|---|---|---|---|
| Epoxy resin (A) | YX-8000 | 55.0 | - | 49.5 | 49.5 | 45 | 45 | - | - | | | 49.5 | 49.5 | 49.5 | 49.5 |
| | Celloxide 2021P | - | 44.6 | - | - | - | - | 41 | 41 | 41 | 41 | | | | |
| Curing agent (B) | MH-700 | 44.5 | 54.9 | 40.1 | 40.1 | 36.5 | 36.5 | 50.4 | 50.4 | 50.4 | 50.4 | 40.1 | 40.1 | 40.1 | 40.1 |
| Curing catalyst | PX-4ET | 0.5 | 0.4 | 0.5 | 0.5 | 0.5 | 0.5 | 0.4 | 0.4 | 0.4 | 0.4 | 0.5 | 0.5 | 0.5 | 0.5 |
| Cross-linked polymer particle (C) | Species | - | - | C-1 | C-2 | C-1 | C-2 | C-3 | C-4 | C-5 | C-6 | - | - | - | - |
| | Amount | - | - | 9.9 | 9.9 | 18.0 | 18.0 | 8.2 | 8.2 | 8.2 | 8.2 | - | - | - | - |
| Core-shell polymer particle (D) | Species | - | - | - | - | - | - | - | - | - | - | D-1 | D-2 | D-1 | D-2 |
| | Amount | - | - | - | - | - | - | - | - | - | - | 9.9 | 9.9 | 18.0 | 18.0 |
| Refractive index (Rm) | | 1.506 | 1,503 | 1.506 | 1.506 | 1.506 | 1.506 | 1.503 | 1.503 | 1.503 | 1.503 | 1.506 | 1.506 | 1.506 | 1.506 |
| Refractive index (Rc) | | - | - | 1.507 | 1.509 | 1.507 | 1.509 | 1.507 | 1.508 | 1.501 | 1.499 | 1.507 | 1.504 | 1.507 | 1.504 |
| Relative Refractive index (Rm/Rc) | | - | - | 0.999 | 0.998 | 0.999 | 0.998 | 0.997 | 0.997 | 1.001 | 1.002 | 0.999 | 1.001 | 0.999 | 1.001 |
| Transmittance [%] | 600 nm | 92.1 | 89.7 | 90.3 | 90.5 | 87.8 | 90.2 | 78.6 | 81.4 | 79.5 | 86.4 | 80.1 | 81.5 | - | - |
| | 450 nm | 90.4 | 87.8 | 88.2 | 89.6 | 83.6 | 88.0 | 71.9 | 74.7 | 72.5 | 81.8 | 78.2 | 80.6 | - | - |
| | 400 nm | 87.1 | 84.9 | 86.4 | 86.7 | 80.1 | 85.5 | 67.8 | 69.7 | 67.8 | 78.8 | 77.7 | 78.8 | - | - |
| Transparency (Haze) [%] | 23°C | 0.6 | 2.6 | 6.4 | 6.6 | 5.6 | 5.5 | 14.1 | 11.0 | 14.3 | 5.7 | 10.8 | 11.7 | - | - |
| | 80°C | 0.6 | 2.4 | 3.9 | 3.7 | 5.9 | 6.3 | 16.8 | 12.5 | 18.5 | 9.0 | 69.3 | 64.0 | - | - |
| Dielectric constant | 10 M | 2.98 | 3.42 | 2.90 | 2.96 | 3.03 | 3.04 | 3.37 | 3.32 | 3.29 | 3.35 | 2.99 | 3.04 | - | - |
| | 100 M | 2.94 | 3.25 | 2.88 | 2.91 | 2.93 | 2.93 | 3.22 | 3.18 | 3.14 | 3.21 | 2.92 | 2.94 | - | - |
| | 1 G | 2.87 | 3.08 | 2.81 | 2.83 | 2.87 | 2.85 | 3.03 | 3.00 | 2.99 | 3.05 | 2.84 | 2.85 | - | - |
| Dielectric tangent | 10M | 0.019 | 0.016 | 0.013 | 0.004 | 0.013 | 0.016 | 0.018 | 0.018 | 0.023 | 0.019 | 0.019 | 0.013 | - | - |
| | 100 M | 0.010 | 0.024 | 0.006 | 0.009 | 0.008 | 0.007 | 0.026 | 0.025 | 0.020 | 0.021 | 0.008 | 0.009 | - | - |
| | 1 G | 0.009 | 0.025 | 0.008 | 0.009 | 0.008 | 0.009 | 0.027 | 0,026 | 0.017 | 0.017 | 0.010 | 0.010 | - | - |
| Crack resistance (cycle no.) | | 4 | 2 | >7 | >7 | >7 | >7 | 6 | 5 | 6 | 5 | >7 | >7 | - | - |

aR.: Reference Example; bE.: Example; cCE.: Comparative Example.

EP 2 664 651 B1

It is clear from Table 3 that the cured material of each Example was not degraded in transparency and was improved in crack resistance, and no temperature dependency of transparency was observed. Also, the electrical characteristics were found to be improved. Accordingly, the cured material of the invention is suitable for applications requiring long-time reliability.

Because the epoxy resin composition of each Reference Example did not contain the cross-linked polymer particle (C), cracks easily formed due to the stress induced in the cooling-heating cycles.

In Comparative Examples 1 to 4, the epoxy resin composition contained a core-shell polymer particle (D) instead of the cross-linked polymer particle (C) of the invention. Hence, the cured material in Comparative Example 1 or 2 was not degraded in transparency and was improved in crack resistance in normal temperature, but did not maintain the transparency at high temperature condition. In Comparative Example 3 or 4, a cured material could not be obtained because remarkable tackification occurred at the blending.

## Claims

1. A cross-linked polymer particle for an epoxy resin, comprising a (meth)acrylate ester monomer unit and a cross-linking monomer unit, having a volume-average primary particle size of 0.5 to 10 $\mu$m, having a glass transition temperature of 30°C or higher that is obtained by the FOX equation (I) with respect to monomer components excluding the cross-linking monomer

$$(I) \quad 1/Tg \ [K] = W1/Tg1 + W2/Tg2$$

(wherein W1 + W2 = 1),
and having a refractive index of 1.490 to 1.510 at 23°C, wherein the refractive index at 23°C is measured according to JIS K7142.

2. The cross-linked polymer particle for an epoxy resin of claim 1, wherein the (meth)acrylate ester monomer unit comprises a monomer unit having cycloalkyl group.

3. The cross-linked polymer particle for an epoxy resin of claim 1 or 2, which is applied to an alicyclic epoxy resin.

4. The cross-linked polymer particle for an epoxy resin of any one of claims 1 to 3, further comprising a vinyl monomer unit having at least one functional group selected from carboxyl, hydroxyl and glycidyl.

5. An epoxy resin composition, comprising the cross-linked polymer particle of any one of claims 1 to 4 (C), an epoxy resin (A), and an epoxy resin curing agent (B).

6. The epoxy resin composition of claim 5, wherein a relative refractive index (Rm/Rc) of a refractive index (Rm) at 23°C of a cured material obtained by curing the epoxy resin (A) and the epoxy resin curing agent (B) with respect to a refractive index (Rc) of the cross-linked polymer particle (C) at 23°C is 0.99 to 1.01, wherein the refractive indices (Rc), (Rm) and (Rm/Rc) at 23°C are measured according to JIS K7142 by using a method as described in the description.

7. The epoxy resin composition of claim 5 or 6, wherein the epoxy resin (A) is an alicyclic epoxy resin, and the epoxy resin curing agent (B) is an alicyclic acid anhydride-type curing agent.

8. A cured epoxy material, being obtained by curing the epoxy resin composition of any one of claims 5 to 7.

9. A LED molding compound, being obtained by curing the epoxy resin composition of any one of claims 5 to 7.

## Patentansprüche

1. Vernetztes Polymerteilchen für ein Epoxyharz, umfassend eine (Meth)Acrlyatestermonomereinheit und eine Vernetzungsmonomereinheit, mit einer volumenmittleren primären Teilchengröße von 0,5 bis 10 $\mu$m, einer Glasübergangstemperatur von 30 °C oder höher, erhalten durch die FOX-Gleichung (I) mit Bezug auf die Monomerkomponenten, ausschließlich des Vernetzungsmonomers

$$1/Tg \: [K] = W1/Tg1 + W2/Tg2$$

(worin W1 + W2 = 1),
und mit einem Brechungsindex von 1,490 bis 1,510 bei 23 °C, wobei der Brechungsindex bei 23 °C gemäß JIS K7142 gemessen wird.

2.  Vernetztes Polymerteilchen für ein Epoxyharz nach Anspruch 1, wobei die (Meth)Acrylatestermonomereinheit eine Monomereinheit mit einer Cycloalkylgruppe umfasst.

3.  Vernetztes Polymerteilchen für ein Epoxyharz nach Anspruch 1 oder 2, welche bei einem alizyklischen Epoxyharz angewandt wird.

4.  Vernetztes Polymerteilchen für ein Epoxyharz nach irgendeinem der Ansprüche 1 bis 3, weiterhin umfassend eine Vinylmonomereinheit mit mindestens einer funktionellen Gruppe, gewählt aus Carboxyl, Hydroxyl und Glycidyl.

5.  Epoxyharzzusammensetzung, umfassend das vernetzte Polymerteilchen nach irgendeinem der Ansprüche 1 bis 4 (C), ein Epoxyharz (A) und ein Epoxyharz-Härtungsmittel (B).

6.  Epoxyharzzusammensetzung nach Anspruch 5, wobei ein relativer Brechungsindex (Rm/Rc) eines Brechungsindex (Rm) bei 23 °C eines gehärteten Materials, erhalten durch Härten des Epoxyharzes (A) und des Epoxyharz-Härtungsmittels (B), mit Bezug auf einen Brechungsindex (Rc) des vernetzten Polymerteilchens (C) bei 23 °C 0,99 bis 1,01 ist, wobei die Brechungsindizes (Rc), (Rm) und (Rm/Rc) bei 23 °C gemessen werden gemäß JIS K7142 durch Verwendung einer in der Beschreibung angegebenen Methode.

7.  Epoxyharzzusammensetzung nach Anspruch 5 oder 6, wobei das Epoxyharz (A) ein alizyklisches Epoxyharz ist, und das Epoxyharz-Härtungsmittel (B) ein Härtungsmittel vom alizyklischen Säureanhydrid-Typ ist.

8.  Gehärtetes Epoxymaterial, erhalten durch Härten der Epoxyharzzusammensetzung nach irgendeinem der Ansprüche 5 bis 7.

9.  LED-Formmasse, erhalten durch Härten der Epoxyharzzusammensetzung nach irgendeinem der Ansprüche 5 bis 7.


**Revendications**

1.  Une particule de polymère réticulé pour une résine époxy, comprenant une unité de monomère d'ester (méth)acrylique et une unité de monomère réticulant, ayant une taille de particule primaire moyenne en volume de 0,5 à 10 μm, ayant une température de transition vitreuse de 30 °C ou supérieure obtenu par l'équation FOX (I) en ce qui concerne les composants monomères en excluant le monomère réticulé

$$1 \: / \: Tg \: [K] = W1/Tg1 + W2/Tg2$$

(dans laquelle W1 + W2 = 1)
et ayant un indice de réfraction de 1,490 à 1,510 à 23 °C, dans lequel l'indice de réfraction à 23 °C est mesuré selon JIS K7142.

2.  La particule de polymère réticulé pour une résine époxy selon la revendication 1, dans laquelle l'unité monomère d'ester (méth)acrylique comprend une unité monomère comportant un groupe cycloalkyle.

3.  La particule de polymère réticulé pour une résine époxy selon la revendication 1 ou 2, qui est appliquée à une résine époxy alicyclique.

**4.** La particule de polymère réticulé pour une résine époxy selon l'une quelconque des revendications 1 à 3, comprenant en outre une unité monomère vinylique ayant au moins un groupe fonctionnel choisi parmi carboxyle, hydroxyle et glycidyle.

**5.** Une composition de résine époxy, comprenant la particule de polymère réticulé de l'une quelconque des revendications 1 à 4 (C), une résine époxy (A) et un agent de durcissement de résine époxy (B).

**6.** La composition de résine époxy selon la revendication 5, dans laquelle un indice de réfraction relatif (Rm / Rc) d'un indice de réfraction (Rm) à 23 °C d'un matériau durci obtenu par durcissement de la résine époxy (A) et de l'agent de durcissement de résine époxy (B) par rapport à un indice de réfraction (Rc) de la particule de polymère réticulé (C) à 23 °C est de 0,99 à 1,01, dans lequel les indices de réfraction (Rc), (Rm) est (Rm/Rc) à 23 °C sont mesurés selon JIS K7142 en utilisant le procédé tel que décrit dans la description.

**7.** La composition de résine époxy selon la revendication 5 ou 6, dans laquelle la résine époxy (A) est une résine époxy alicyclique et l'agent de durcissement de résine époxy (B) est un agent de durcissement du type anhydride d'acide alicyclique.

**8.** Un matériau époxy durci obtenu en durcissant la composition de résine époxy selon l'une quelconque des revendications en 5 à 7.

**9.** Un composé de moulage LED, obtenu par durcissement de la composition de résine époxy selon l'une quelconque des revendications en 5 à 7.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003082062 A
- JP 2010053199 A
- WO 2010013407 A
- JP 2010090371 A

**Non-patent literature cited in the description**

- Polymer Handbook. John Wiley & Sons Inc,